# EUROPEAN PATENT APPLICATION

(11) **EP 4 683 345 A1**
(43) Date of publication of application: **21.01.2026**
(21) Application number: 25189599.1
(22) Date of filing: 15.07.2025
(51) Int. Cl.: H04R 1/20, H04R 1/02

(54) **SPLITTABLE SPEAKER ASSEMBLY**

(30) Priority: 17.07.2024 CN 202421704527 U
(71) Applicant: Shenzhen Oceanwing Smart Innovations Technology Co., Ltd, Shenzhen City, Guangdong Province 518055 (CN)
(72) Inventor: Zheng, Pan, Shenzhen City, Guangdong Province, 518055 (CN)
(74) Representative: Wörz, Volker Alfred

(57) **Abstract**

A splittable speaker assembly is disclosed. For the splittable speaker assembly, the driving structure (4) is movably connected to the main speaker (1) and abuts against an end of the buckle structure (3) to drive the buckle structure (3) to move. In a case where the driving structure (4) is moved to a first state relative to the main speaker (1), the buckle structure (3) is moved to a position where the buckle structure (3) is engaged with the mating portion (21), such that the auxiliary speaker (2) is engaged with the main speaker (1). In a case where the driving structure (4) is moved to a second state relative to the main speaker (1), the buckle structure (3) is moved to a position where the buckle structure (3) is separated from the mating portion (21), such that the auxiliary speaker (2) is disengaged from the main speaker (1).

## Description

### TECHNICAL FIELD

Embodiments of the present disclosure relate to the field of speaker technologies, and in particular to a splittable speaker assembly.

### BACKGROUND

As common consumer electronics in people's daily life, speakers have become ubiquitous in households. To pursue enhanced audio experiences, splittable speaker assemblys can be positioned around users to provide an immersive surround music experience.

This leads to an issue of how to assemble satellite speakers or auxiliary speakers with main speakers. In the related art, the auxiliary speakers are generally assembled with the main speakers by magnetic attraction. However, the assembling achieved by magnetic attraction is not stable enough, and the auxiliary speakers are easily separated from the main speakers.

### SUMMARY

Some embodiments of the present disclosure provide a splittable speaker assembly.

According to a first aspect of some embodiments of the present disclosure, a splittable speaker assembly is provided. The splittable speaker assembly includes a main speaker, an auxiliary speaker including a mating portion; a buckle structure movably connected to the main speaker; and a driving structure, movably connected to the main speaker and abutting against an end of the buckle structure to drive the buckle structure to move. The mating portion is capable of being mated with the buckle structure. In a case where the driving structure is moved to a first state relative to the main speaker, the buckle structure is moved to a position where the buckle structure is engaged with the mating portion, such that the auxiliary speaker is engaged with the main speaker. In a case where the driving structure is moved to a second state relative to the main speaker, the buckle structure is moved to a position where the buckle structure is separated from the mating portion, such that the auxiliary speaker is disengaged from the main speaker.

It should be understood that the above general description and the detailed description that follows are exemplary and explanatory only and do not limit the present disclosure.

### BRIEF DESCRIPTION OF THE DRAWINGS

The drawings herein, which are incorporated into the specification and constitute a part of the specification, illustrate embodiments consistent with the present disclosure and are used together with the specification to explain the principles of the present disclosure.

In order to more clearly illustrate the technical solutions in the embodiments of the present disclosure or related art, the accompanying drawings to be used in the description of the embodiments or related art will be briefly described below. Obviously, those skilled in the art can also obtain other drawings based on these drawings without creative efforts.

One or more embodiments are illustrated exemplarily by means of pictures in the corresponding drawings. The exemplary illustrations do not limit the embodiments. Elements having identical reference numerals in the accompanying drawings represent similar elements. Unless expressly stated, the figures in the drawings are not drawn to scale.
FIG. 1 is an exploded schematic view of a splittable speaker assembly illustrated according to some embodiments of the present disclosure.
FIG. 2 is a schematic view of the splittable speaker assembly in an assembled state according to some embodiments of the present disclosure.
FIG. 3 is a schematic view of a buckle structure of the splittable speaker assembly according to some embodiments of the present disclosure.
FIG. 4 is a partial schematic view of a rear shell according to some embodiments of the present disclosure.
FIG. 5 is a partial schematic view of a splittable speaker assembly according to some embodiments of the present disclosure.
FIG. 6 is an exploded schematic view of a splittable speaker assembly according to some embodiments of the present disclosure.
FIG. 7 is a schematic view of the splittable speaker assembly in an assembled state according to some embodiments of the present disclosure.
FIG. 8 is a partial schematic view of the splittable speaker assembly according to some embodiments of the present disclosure.

In the drawings:
1, main speaker; 11, housing; 111, front shell; 112, rear shell; 1121, strip-shaped hole; 1122, carrying handle slot; 12, second magnetic structure; 2, auxiliary speaker; 21, mating portion; 22, first magnetic structure; 3, buckle structure; 31a, first engaging portion; 32a, first sliding portion; 31b, second engaging portion; 32b, second sliding portion; 33,elastic member; 4, driving structure; 41a, first carrying handle portion; 42a, bracket portion; 421, positioning protrusion; 41b, second carrying handle portion; 42b, cam mechanism; 421, rotating shaft; 5, protective cover; 51, first positioning groove; 52, second positioning groove; 61, first rolling structure; 62, second rolling structure.

### DETAILED DESCRIPTION

To make the objectives, technical solutions, and advantages of the embodiments of the present disclosure clearer, the technical solutions in the embodiments of the present disclosure will be described clearly and completely in conjunction with the drawings in the embodiments of the present disclosure. Obviously, the described embodiments are part of the embodiments of the present disclosure, rather than all of them. Based on the embodiments in the present disclosure, all other embodiments obtained by those skilled in the art without creative efforts shall fall within the protection scope of the present disclosure.

The following disclosure provides numerous different embodiments or examples for implementing various structures of the present disclosure. To simplify the present disclosure, components and arrangements of specific examples are described below. Of course, these are merely examples and are not intended to limit the present disclosure. In some embodiments, the present disclosure may repeat reference numerals and/or letters in different examples. Such repetition is for the purpose of simplicity and clarity, and does not indicate any relationship between the various embodiments and/or arrangements discussed. Furthermore, the present disclosure provides examples of various specific processes and materials, but those skilled in the art will recognize the applicability of other processes and/or the use of other materials.

For the convenience of description, spatially relative terms may be used herein to describe the relative positional relationship or movement of one element or feature with respect to another element or feature as shown in the drawings. Such relative terms include "inside", "outside", "inner side", "outer side", "below", "beneath", "above", "over", "front", "rear", etc. These spatially relative terms are intended to encompass different orientations of the device in use or operation, in addition to the orientation depicted in the drawings. For example, if the device in the drawing is turned over, changes its posture, or alters its state of motion, these directional indications will correspondingly change. For instance, an element described as "below" or "beneath" other elements or features will subsequently be oriented "above" or "over" such elements or features. Therefore, the exemplary term "below" may include both upper and lower orientations. The device may be otherwise oriented (rotated by 90 degrees or in other directions), and the spatially relative descriptors used herein shall be interpreted accordingly.

In order to solve the technical problems that the assembling of the auxiliary speakers with the main speakers is stable enough and the auxiliary speakers are easily separated from the main speakers, some embodiments of the present disclosure provide a splittable speaker assembly. In the splittable speaker assembly according to some embodiments of the present disclosure, the driving structure is movably connected to the main speaker, and the driving structure abuts against an end of the buckle structure to drive the buckle structure to move. In this way, in a case where the driving structure is moved to the first state relative to the main speaker, the buckle structure is moved to the position where the buckle structure is engaged with the mating portion, such that the auxiliary speaker may be engaged with or fitted with the main speaker, and thus the auxiliary speaker may be stably assembled with the main speaker. In a case where the driving structure is moved to the second state relative to the main speaker, the buckle structure is moved to the position where the buckle structure is separated from the mating portion, such that the auxiliary speaker may be disengaged from the main speaker, thereby facilitating the separation of the auxiliary speaker from the main speaker. In other words, the splittable speaker assembly may have better the stability in a case where the auxiliary speaker is assembled with the main speaker, the operation of the assembling and splitting/separation of the splittable speaker assembly may be facilitated, and the use experience may be improved.

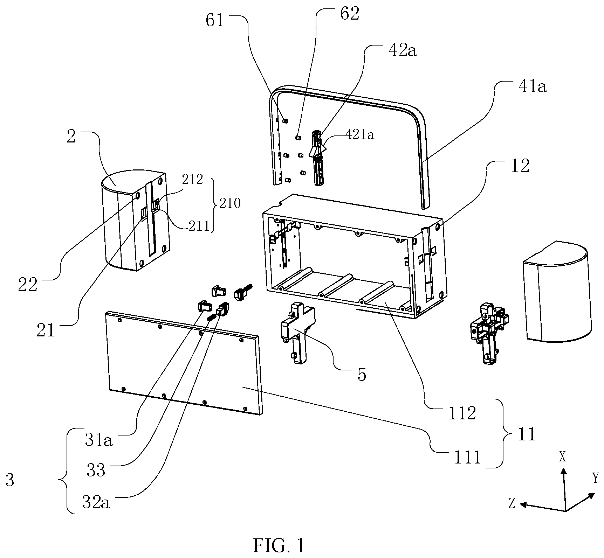

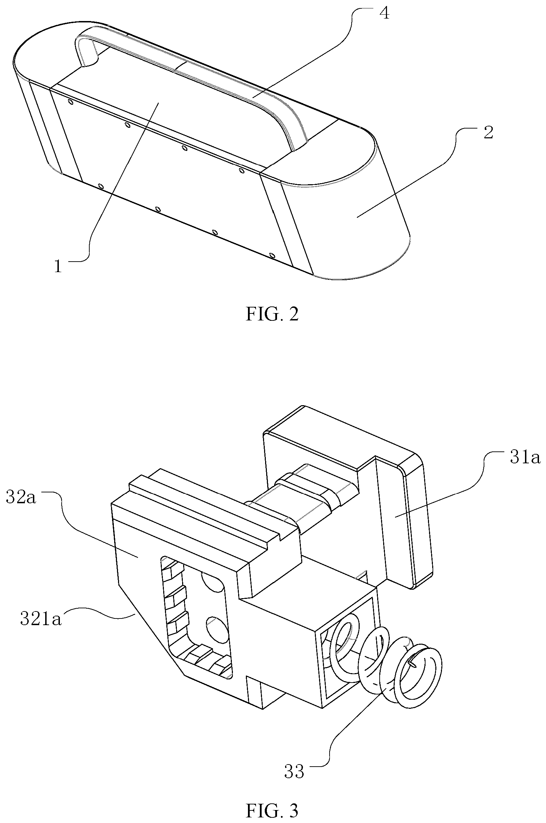

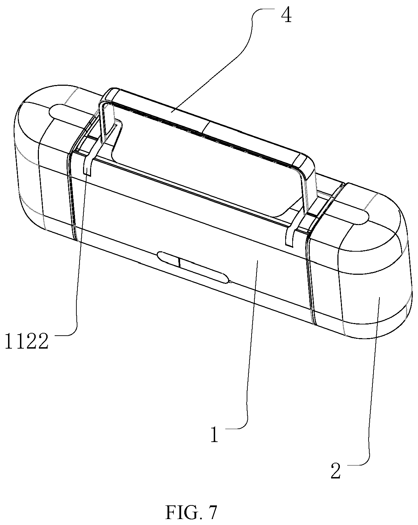

In some embodiments, a splittable speaker assembly is provided. As shown in FIGS. 1 and 2, or FIGS. 6 and 7, the splittable speaker assembly may include a main speaker 1, an auxiliary speaker 2 (the auxiliary speaker may also be called as "satellite speaker"), a driving structure 4, and a buckle structure 3. The driving structure 4 may be mounted on the main speaker 1 and movably connected to the main speaker 1. For example, the driving structure 4 may be rotatably connected to the main speaker 1 by a structure such as a rotating shaft, etc., or may be slidably connected to the main speaker 1 by a structure such as a slider, a rolling ball, etc., which is not limited herein.

In some embodiments, the auxiliary speaker 2 may include a mating portion 21 that is capable of being mated with the buckle structure 3. It is to be noted that, in a case where the splittable speaker assembly includes one auxiliary speaker 2, the splittable speaker assembly may include one buckle structure 3 corresponding to the auxiliary speaker 2. In a case where the splittable speaker assembly includes two auxiliary speakers 2, the splittable speaker assembly may include two buckle structures 3, and the two buckle structures 3 and the two auxiliary speakers 2 are in one-to-one correspondence. That is, each auxiliary speaker 2 may be configured with one buckle structure 3.

In some embodiments, the buckle structure 3 may be movably connected to the main speaker 1. The driving structure 4 may abut against an end of the buckle structure 3 to drive the buckle structure 3 to move.

In a case where the driving structure 4 is moved to a first state relative to the main speaker 1, the buckle structure 3 may be moved to a position where the buckle structure 3 is engaged with the mating portion 21, such that the auxiliary speaker 2 may be engaged with or fitted with or mated with the main speaker 1, and thus the main speaker 1 may be stably assembled with the auxiliary speaker 2. In a case where the driving structure 4 is moved to a second state relative to the main speaker 1, the buckle structure 3 may be moved to a position where the buckle structure 3 is separated from the mating portion 21, such that the auxiliary speaker 2 may be disengaged from the main speaker 1, thereby facilitating the separation of the auxiliary speaker 2 from the main speaker 1.

In some embodiments, an elastic member 33 may be arranged on another end of the buckle structure 3. The another end of the buckle structure 3 is opposite to the end configured to abut against the driving structure 4. In a case where the auxiliary speaker 2 and the main speaker 1 are in an assembled state, the elastic member 33 is in a state of elastic deformation, and an elastic force generated by the elastic deformation of the elastic member 33 is configured to enable or cause the buckle structure 3 to move toward the driving structure 4.

In some embodiments, the driving structure 4 may include a carrying handle portion. The first state may be, for example, a state in which a user lifts or raises the driving structure 4 via the carrying handle portion. The second state may be, for example, a state in which the user presses, lowers, or puts down the driving structure 4 via the carrying handle portion.

In some embodiments, during the movement of the driving structure 4 to the first state of the driving structure 4 relative to the main speaker 1, the driving structure 4 may be moved in a direction of pressing the buckle structure 3. Since the driving structure 4 abuts against the buckle structure 3, the driving structure 4 may synchronously drive the buckle structure 3 to move. When the driving structure 4 is in the first state, the buckle structure 3 may be in a position where the buckle structure 3 is engaged with the mating portion 21, such that the auxiliary speaker 2 may be engaged with or fitted with the main speaker 1, and thus the main speaker 1 may be stably assembled with the auxiliary speaker 2.

During the movement of the driving structure 4 to the second state of the driving structure 4 relative to the main speaker 1, the driving structure 4 is moved in a direction opposite to the direction of pressing the buckle structure 3. At this time, the elastic member 33 is in the state of elastic deformation, and the elastic force generated by the elastic deformation of the elastic member 33 may cause the buckle structure 3 to move in the direction close to or towards the driving structure 4. That is to say, under this circumstance, the buckle structure 3 may be still moved along with the driving structure 4 under the elastic force of the elastic member 33. The buckle structure 3 may remain abutting against the driving structure 4, and finally be moved to a position where the buckle structure 3 is separated from the mating portion 21 under the action of the elastic member 33. In this way, the auxiliary speaker 2 may be disengaged from the main speaker 1, thereby facilitating the separation of the auxiliary speaker 2 from the main speaker 1.

In some other embodiments, the driving structure 4 may include a carrying handle portion, a pressing device, a pullable switch, an electric switch, etc. In some embodiments, the driving structure 4 may be a control button on a mobile application that is wirelessly connected to the speaker device (i.e., the splittable speaker assembly). In some embodiments, the driving structure 4 takes a handle portion as an example. The first state may be, for example, a state in which the user lifts or raises the driving structure 4 via the carrying handle portion. The second state may be, for example, a state in which the user presses, lowers, or puts down the driving structure 4 via the carrying handle portion.

During the movement of the driving structure 4 to the first state relative to the main speaker 1, the driving structure 4 is moved in the direction opposite to the direction of pressing the buckle structure 3. At this time, the elastic member 33 is in the state of elastic deformation, and the elastic force generated by the elastic deformation of the elastic member 33 may cause the buckle structure 3 to move in the direction close to or towards the driving structure 4. That is to say, under this circumstance, the buckle structure 3 may be still moved along with the driving structure 4 under the elastic force of the elastic member 33. The buckle structure 3 may remain abutting against the driving structure 4, and finally be moved to a position where the buckle structure 3 is engaged with the mating portion 21, such that the auxiliary speaker 2 may be engaged with or fitted with the main speaker 1, and thus the main speaker 1 may be stably assembled with the auxiliary speaker 2.

During the movement of the driving structure 4 to the second state relative to the main speaker 1, the driving structure 4 may be moved in the direction of pressing the buckle structure 3. Since the driving structure 4 abuts against the buckle structure 3, the driving structure 4 may synchronously drive the buckle structure 3 to move, and the buckle structure 3 may be moved to a position where the buckle structure 3 is separated from the mating portion 21 under the action of the driving structure 4. In this way, the auxiliary speaker 2 may be disengaged from the main speaker 1, thereby facilitating the separation of the auxiliary speaker 2 from the main speaker 1.

It is to be noted that the driving structure 4 and the buckle structure 3 may be mated/fitted/engaged with each other in other ways in addition to the above ways, which is not limited herein.

In the splittable speaker assembly according to some embodiments of the present disclosure, an end of the buckle structure 3 abuts against the driving structure 4, the another end of the buckle structure 3 is provided with the elastic member 33, and the state of elastic deformation of the elastic member 33 is configured to keep the buckle structure 3 to be moved to along with the driving structure 4. In a case where the driving structure 4 is moved to the first state relative to the main speaker 1, the buckle structure 3 is moved to a position where the buckle structure 3 is engaged with the mating portion 21, such that the auxiliary speaker 2 may be engaged with or fitted with the main speaker 1, and thus the main speaker 1 may be stably assembled with the auxiliary speaker 2. In a case where the driving structure 4 is moved to the second state relative to the main speaker 1, the buckle structure 3 is moved to a position where the buckle structure 3 is separated from the mating portion 21, such that the auxiliary speaker 2 may be disengaged from the main speaker 1, thereby facilitating the separation of the auxiliary speaker 2 from the main speaker 1. In other words, the splittable speaker assembly may have better the stability in a case where the auxiliary speaker 2 is assembled with the main speaker 1, the operation of the assembling and splitting/separation of the splittable speaker assembly may be facilitated, and the use experience may be improved.

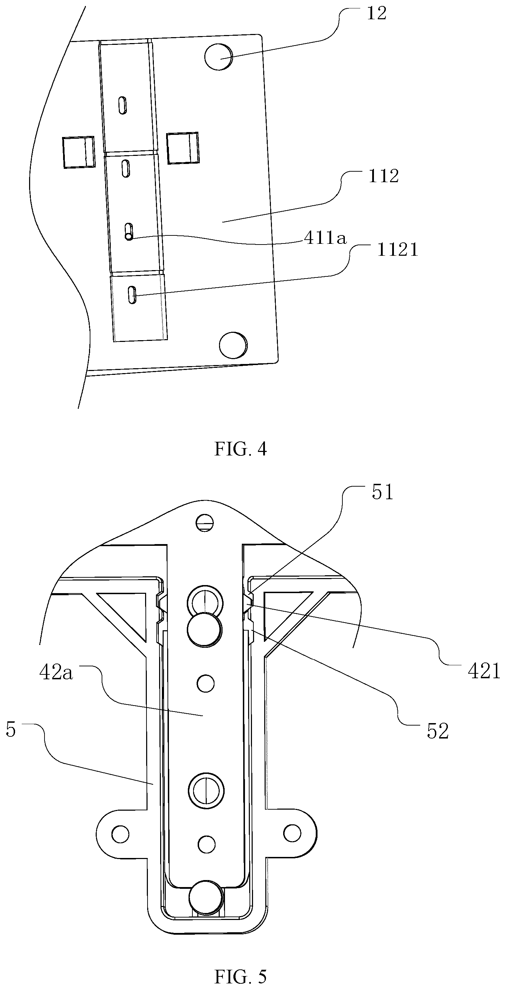

In some embodiments, a splittable speaker assembly may be provided. As shown in FIGS. 1 to 5, the driving structure 4 may be slidably connected to the main speaker 1, and a sliding direction of the driving structure 4 may be a first direction X. The buckle structure 3 may be slidably connected to the main speaker 1, and a sliding direction of the buckle structure 3 may be a second direction Y. The first direction X and the second direction Y may be substantially perpendicular to each other. For example, the first direction X may be a height direction of the splittable speaker assembly, and the second direction Y may be a thickness direction of the splittable speaker assembly.

In a case where the driving structure 4 slides in the first direction X relative to the main speaker 1 to the first state, the buckle structure 3 may slide in the second direction Y to a position where the buckle structure 3 is engaged with the mating portion 21, such that the auxiliary speaker 2 may be engaged with or fitted with the main speaker 1. In a case where the driving structure 4 slides in the first direction X relative to the main speaker 1 to the second state, the buckle structure 3 may slide in the second direction Y to a position where the buckle structure 3 is separated from the mating portion 21, such that the auxiliary speaker 2 may be disengaged from the main speaker 1.

In some embodiments, the mating portion 21 may include an engaging groove 210 defined on the auxiliary speaker 2. The engaging groove 210 may include a first portion 211 and a second portion 212. The first portion 211 may be recessed in a third direction Z and away from the buckle structure 3. The second portion 212 may be recessed in the second direction Y and away from the driving structure 4. The third direction Z may be substantially perpendicular to the first direction X, and the third direction Z may be substantially perpendicular to the second direction Y. For example, in a case where the first direction X is the height direction of the splittable speaker assembly and the second direction Y is the thickness direction of the splittable speaker assembly, the third direction Z may be a length direction of the splittable speaker assembly.

In some embodiments, the buckle structure 3 may include a first engaging portion 31a and a first sliding portion 32a. The first engaging portion 31a may be fixedly connected to the first sliding portion 32a. The buckle structure 3 may abut against the driving structure 4 via an end of the first sliding portion 32a. The elastic member 33 may be disposed at another end of the first sliding portion 32a. The first sliding portion 32a may be configured to drive the first engaging portion 31a to slide in the second direction Y.

In the splittable speaker assembly according to some embodiments of the present disclosure, in a case where the driving structure 4 is in the first state, the first sliding portion 32a may drive the first engaging portion 31a to be at least partially engaged into the second portion 212 of the engaging groove 210, such that the auxiliary speaker 2 may be stably assembled with the main speaker 1. In a case where the driving structure 4 is in the second state, the first sliding portion 32a may drive the first engaging portion 31a to be removed from the second portion 212, such that the first engaging portion 31a may be located in the first portion 211 of the engaging groove 210, thereby facilitating the removal of the first engaging portion 31a from the engaging groove 210 and further facilitating the separation of the auxiliary speaker 2 from the main speaker 1.

In some embodiments, an end of the first sliding portion 32a may have a first inclined surface 321a, and the driving structure 4 may have a second inclined surface 421a. The first inclined surface 321a may abut against the second inclined surface 421a. The elastic member 33 may be a spring. When the driving structure 4 slides upwardly in the first direction X, the cooperation between the first inclined surface 321a and the second inclined surface 421a may drive the first sliding portion 32a to move away from the second inclined surface 421a in the second direction Y, thereby enabling the first engaging portion 31a to be moved away from the second inclined surface 421a in the second direction Y. Since the engaging groove 210 defined on the auxiliary speaker 2 includes the second portion 212 recessed in the second direction Y and away from the driving structure 4, when the first engaging portion 31a is moved in the direction away from the second inclined surface 421a, the first engaging portion 31a may be engaged or snapped into the second portion 212 of the engaging groove 210 via the first portion 211 of the engaging groove 210, such that the auxiliary speaker 2 may be stably assembled with the main speaker 1. When the driving structure 4 slides downwardly along the first direction X, the elastic member 33 (spring) may drive the first sliding portion 32a to move towards or close to the second inclined surface 421a in the second direction Y, such that the first engaging portion 31a may be moved towards or close to the second inclined surface 421a in the second direction Y. In this way, the first engaging portion 31a may be returned to the first portion 211 of the engaging groove 210 from the second portion 212 of the engaging groove 210, such that the first engaging portion 31a may be disengaged from the second portion 212 of the engaging groove 210. An opening of the first portion 211 of the engaging groove 210 faces the main speaker 1. By moving the auxiliary speaker 2 away from the main speaker 1 in the third direction Z, the main speaker 1 may be separated from the auxiliary speaker 2, thereby facilitating the separation of the auxiliary speaker 2 from the main speaker 1.

In some embodiments, the main speaker 1 may include a housing 11. The housing 11 may define at least one through hole 1121. The through hole 1121 may be strip-shaped. The through hole 1121 may extend in the first direction X. The driving structure 4 may include a first carrying handle portion 41a and a bracket portion 42a. The first carrying handle portion 41a may be disposed on an outer side of the housing 11. The bracket portion 42a may be disposed on an inner side of the housing 11. The driving structure 4 may abut against the buckle structure 3 via the bracket portion 42a.

For example, the bracket portion 42a of the driving structure 4 may have the second inclined surface 421a, the first sliding portion 32a of the buckle structure 3 may have the first inclined surface 321a, and the first inclined surface 321a may abut against the second inclined surface 421a to facilitate the relative sliding between the driving structure 4 and the buckle structure 3.

In some embodiments, the first carrying handle portion 41a may be fixedly connected to the bracket portion 42a through a fastener 411a and the through hole 1121. The fastener 411a may cooperate with the through hole 1121 to limit or restrict the sliding of the driving structure 4 relative to the main speaker 1. That is, the fastener 411a is slidable only within the through hole 1121, such that the driving structure 4 is limited to be slidable only in the first direction X. It is to be noted that, the fastener 411a may include a screw, a rivet, or other structures, which is not limited herein.

In some embodiments, the number of the through holes 1121 may not be limited, and similarly, the number of fasteners 411a may not be limited. It should be noted that, each of the through holes 1121 may be configured with one fastener. In a case where the housing 11 defines a plurality of through holes 1121, a plurality of fixing positions may be provided for the fixed connection between the bracket portion 42a and the first handle portion 41a, which may better ensure the reliability of the fixed connection between the bracket portion 42a and the first handle portion 41a.

In some embodiments, the bracket portion 42a may include a positioning protrusion 421.The splittable speaker assembly may further include a positioning portion 5 that is connected to the housing 11. "Connected" herein may include a case that the positioning portion 5 is integrally molded with the housing 11 or a case that the positioning portion 5 is fixedly connected to the housing 11, which is not limited herein.

In some embodiments, the positioning portion 5 may be a protective cover covering an outer side of the bracket portion 42a. The protective cover may define a first positioning groove 51 which is capable of being mated or cooperating with the positioning protrusion 421. In a case where the driving structure 4 is in the first state, the positioning protrusion 421 may be engaged into the first positioning groove 51 to ensure that the driving structure 4 remains stably in the first state without sliding downwardly due to the gravity.

In some embodiments, the protective cover may further define a second positioning groove 52 that mates or cooperates with the positioning protrusion 421. In a case where the driving structure 4 is in the second state, the positioning protrusion 421 may be engaged into the second positioning groove 52 to ensure that the driving structure 4 may be stably in the second state, and to reduce the occurrence of the driving structure 4 sliding downwardly due to the gravity. It is to be noted that, by configuring the positioning projection 421 and the second positioning groove 52, it can be better ensured that the first engaging portion 31a is stably in the first portion 211 of the engaging groove 210, thereby further facilitating the separation of the auxiliary speaker 2 from the main speaker 1.

In some embodiments, a first rolling structure 61 may be arranged on a side of the first carrying handle portion 41a close to the bracket portion 42a. It is to be noted that due to the large size of the first carrying handle portion 41a in the first direction X, sliding motion of the first carrying handle portion 41a along the first direction X may easily cause the compression between the first carrying handle portion 41a and the housing 11, which results in the obstruction of the sliding of the first carrying handle portion 41a. By arranging the first rolling structure 61, the obstruction of sliding of the first carrying handle portion 41a relative to the housing 11 may be reduced, thereby better ensuring that the first carrying handle portion 41a slides smoothly relative to the housing 11.

In some embodiments, a second rolling structure 62 may be arranged on a side of the bracket portion 42a close to the first carrying handle portion 41a. Similarly, since the bracket portion 42a and the first carrying handle portion 41a are able to simultaneously slide in the first direction X relative to the housing 11, arranging the second rolling structure 62 on the bracket portion 42a can better reduce the obstruction of the movement of the bracket portion 42a relative to the housing 11, thereby better ensuring that the bracket portion 42a slides smoothly relative to the housing 11. Thus, it is possible to ensure that the driving structure 4 slides smoothly relative to the housing 11

For example, each the first rolling structure 61 and the second rolling structure 62 may include a plurality of ball plunger structures arranged along the first direction X. Each ball plunger structure may include a ball, a spring, and a placement structure for accommodating the ball and the spring. The placement structure may be fixedly connected to the first carrying handle portion 41a. In some embodiments, the placement structure may be fixedly connected to the first carrying handle portion 41a by means of adhesive bonding. Certainly, the placement structure may also be fixedly connected to the first carrying handle portion 41a by means of clamping or other methods, which is not limited herein.

In some embodiments, the auxiliary speaker 2 may include at least one first magnetic structure 22 (e.g., a magnet). The main speaker 1 may include at least one second magnetic structure 12 (e.g., a magnet). The auxiliary speaker 2 and the main speaker 1 may be magnetically connected to each other by magnetic attraction between the at least one first magnetic structure 22 and the at least one second magnetic structure 12. It should be noted that, in the state where the auxiliary speaker 2 is magnetically connected to the main speaker 1, the buckle structure 3 may be aligned with the mating portion 21.

In some embodiments, the splittable speaker assembly may include the main speaker 1 and the auxiliary speaker 2. The main speaker 1 may include the housing 11. The housing 11 may include a front shell 111 and a rear shell 112.

During assembly, magnets may be arranged on the left and right (it should be noted that the left-right direction may refer to the third direction Z) sides of the rear shell 112 by means of, e.g., adhesive bonding. Corresponding magnets may be arranged at corresponding positions of the auxiliary speaker 2 by means of, e.g., adhesive bonding, to facilitate the initial magnetic connection between the auxiliary speaker 2 and the main speaker 1 when assembling the auxiliary speaker 2 with the main speaker 1.

In some embodiments, it is possible to assemble three ball plungers on the first carrying handle portion 41a by means of, e.g., adhesive bonding, and further assemble another three ball plungers on the bracket portion 42a by means of, e.g., adhesive bonding. The first carrying handle portion 41a and the bracket portion 42a may be fixed together with the rear shell 112 by means of, e.g., a screw, thereby achieving the assembling of the driving structure 4 and the housing 11. When fixing the driving structure 4 to the rear shell 112, the second inclined surface 421a of the bracket portion 42a may well mate or cooperate with the first inclined surface 321a at the first end of the first sliding portion 32a of the buckle structure 3, and the spring (the elastic member 33) may be assembled at the another end of the first sliding portion 32a. Then, the positioning portion (protective cover) 5 may be disposed on and cover the outer side of the assembly formed by the bracket portion 42a and the first sliding portion 32a. The protective cover 5 may be fixedly connected to the rear shell 112 by means of. e.g., a screw. It should be noted that the above-mentioned structures, such as the bracket portion 42a, the buckle structure 3, the protective cover 5, etc., may be disposed on both the left and right sides of the rear shell 112.

In some embodiments, when it is necessary to separate the auxiliary speaker 2 from the main speaker 1, the first carrying handle portion 41a may be pressed downwardly (the up-down direction may be referred to as the first direction X) to the second state, the bracket portion 42a of the driving structure 4 may move downwardly along with the first carrying handle portion 41a, the second inclined surface 421a of the bracket portion 42a may cooperate with the first inclined surface 321a of the first sliding portion 32a, and the first sliding portion 32a may move towards the middle of the main speaker 1 (i.e., in a direction close to the bracket portion 42a) due to the impact of the spring (the elastic member 33). Since the first engaging portion 31a is fixedly connected to the first sliding portion 32a, the first engaging portion 31a may be able to move to the middle of the main speaker 1along with the first sliding portion 32a and move to the first portion 211 of the engaging groove 210 from the second portion 212 of the engaging groove 210. The first engaging portion 31a may be disengaged or exited from the second portion 212 of the engaging groove 210, and the auxiliary speaker 2 may be removed or detached from the main speaker 1. Besides, due to the configuration of the positioning protrusion 421 and the positioning engaging groove (i.e., the first positioning groove 51 and the second positioning groove 52), the state of the driving structure 4 will not be affected by the gravity.

In some embodiments, when it is necessary to assemble the auxiliary speaker 2 with the main speaker 1, the auxiliary speaker 2 may be disposed close to a side surface of the main speaker 1. Magnets are arranged at four corners of each of the side surface of the main speaker 1 and a corresponding side surface of the auxiliary speaker 2, and the auxiliary speaker 2 and the main speaker 1 may attract each other by the magnets. Besides, the first engaging portion 31a of the buckle structure 3 may be engaged into the first portion 211 of the engaging groove 210. Since the first engaging portion 31a is disengaged from the second portion 212 of the engaging groove 210, the first engaging portion 31a will not affect the assembling of the auxiliary speaker 2. When the splittable speaker assembly needs to be moved, as the first carrying handle portion 41a is lifted up to the first state, the bracket portion 42a may be moved upwardly along with the first carrying handle portion 41a, driving the first sliding portion 32a to move to the side of the main speaker 1, the first sliding portion 32a drives the corresponding first engaging portion 31a to move together, the first engaging portion 31a may be engaged and locked into the second portion 212 of the engaging groove 210, and the main speaker 1 may be stably fixed with the auxiliary speaker 2.

For the splittable speaker assembly in some embodiments of the present disclosure, through the cooperation among the driving structure 4, the buckle structure 3, the engaging groove 210, and other structures, when the user is using the splittable speaker assembly, the assembling or separation of the main speaker 1 and the auxiliary speaker 2 may be completed by only one action of operating the handle portion. Besides, the splittable speaker assembly may have better the stability in a case where the auxiliary speaker 2 is assembled with the main speaker 1, the operation of the assembling and splitting/separation of the splittable speaker assembly may be facilitated, and the use experience may be improved.

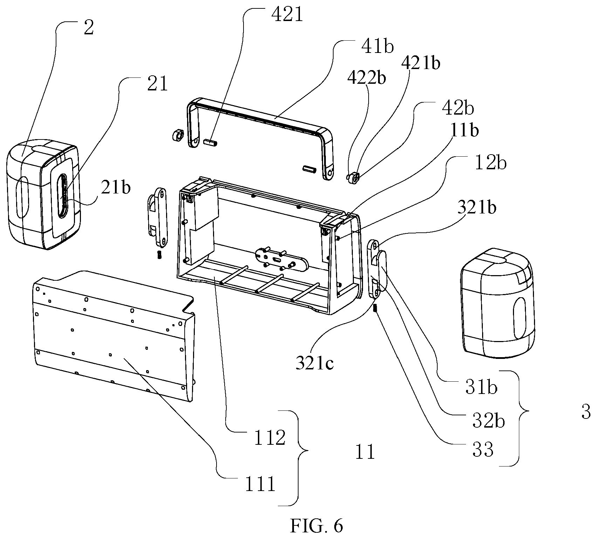

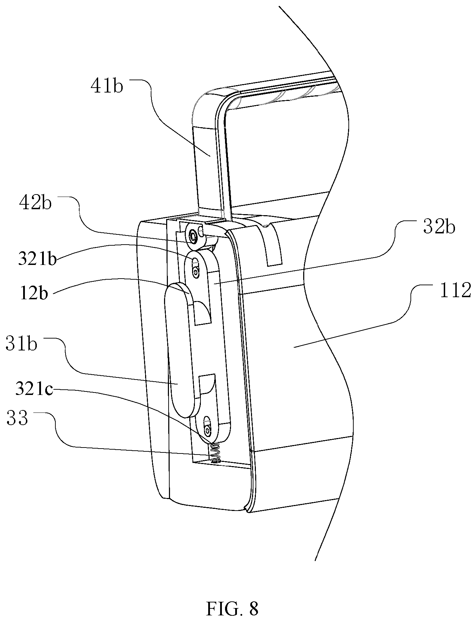

In some embodiments, a splittable speaker assembly is provided. As shown in FIGS. 6 to 8, the splittable speaker assembly shown in FGIS. 6 to 8 may include a main speaker 1, an auxiliary speaker 2, a driving structure 4, and a buckle structure 3. The main speaker 1, the auxiliary speaker 2, the driving structure 4, and the buckle structure 3 may have configurations similar to the embodiments shown in FIGS. 1-5, and similar configurations may refer to the description above, which is not repeated here. The driving structure 4 may be rotatably connected to the main speaker 1. For example, the driving structure 4 may be rotatably connected to the main speaker 1 via a rotating shaft 421.

In some embodiments, the driving structure 4 may include a second carrying handle portion 41b and a cam mechanism 42b. The second carrying handle portion 41b may be fixedly connected to the cam mechanism 42b. For example, the cam structure 42b and the second carrying handle portion 41b may be fixedly connected by fasteners such as screws, bolts, and the like. A cam 421b of the cam mechanism 42b may abut against an end of the buckle structure 3 to facilitate driving the buckle structure 3 to move when the cam 421b rotates. The elastic member 33 is disposed at another opposite end of the buckle structure 3.

In a case where the driving structure 4 is moved to the first state relative to the main speaker 1, the second carrying hand portion 41b may drive the cam 421b of the cam mechanism 42b to move in the direction opposite to of the direction of pressing the buckle structure 3. At this time, the elastic member 33 is in the state of elastic deformation, the elastic force generated by the elastic deformation of the elastic member 33 may cause the buckle structure 3 to move in a direction close to the cam 421b, and the buckle structure 3 may keep abutting against the cam 421b. Ultimately, the buckle structure 3 may slide to a position where the buckle structure 3 is engaged with the mating portion 21 under the action of the elastic member 33, such that the auxiliary speaker 2 may be fitted or assembled with the main speaker 1, and thus the main speaker 1 may be stably assembled with the auxiliary speaker 2.

In a case where the driving structure 4 is moved to the second state relative to the main speaker 1, the second carrying handle portion 41b may drive the cam 421b of the cam mechanism 42b to move in the direction of pressing the buckle structure 3. Since the cam 421b abuts against the buckle structure 3, the cam 421b is able to drive the buckle structure 3 to slide. The buckle structure 3 may slide to a position where the buckle structure 3 is separated from the mating portion 21 under the action of the cam 421b of the cam mechanism 42b, to split or separate the auxiliary speaker 2 from the main speaker 1.

The main speaker 1 may define a first limiting hole 11b. The first limiting hole 11b may be in shape of an arc. A first limiting post 422b may be disposed on the cam 421b. The first limiting post 422b may be disposed within the first limiting hole 11b and configured to limit the rotation of the driving structure 4 relative to the main speaker 1. In addition, a second limiting post 12b may be disposed on the main speaker 1, and the buckle structure 3 may further define a second limit hole 321b. The second limit hole 12b may extend in the first direction X. The second limit post 321b may be disposed within the second limit hole 12b and configured to limit the sliding of the buckle structure 3 relative to the main speaker 1. As a result, when the cam 421b rotates, it can be determined that the buckle structure 3 is moved in the first direction X. In some embodiments, the limiting post may also be replaced by limiting protrusion or other limiting member with any suitable structures, as long as the limiting member can be disposed within the corresponding limiting hole and have the similar limiting function to the rotation of the driving structure 4 or sliding of the buckle structure 3.

In some embodiments, the buckle structure 3 may include a second engaging portion 31b and a second sliding portion 32b. The second engaging portion 31b may be connected to the second sliding portion 32b ("connected" means that the two components may be formed into a one-piece structure or may be two separate structures fixedly connected to each other). The buckle structure 3 may abut against the driving structure 4 via the second sliding portion 32b. The second sliding portion 32b may be configured to drive the second engaging portion 31b to slide relative to the main speaker 1.

In some embodiments, the mating portion 21 may include a notch 21b defined on the auxiliary speaker 2. The size of the notch 21b may match with the size of the second engaging portion 31b. That is, the size of the notch 21b may be slightly greater than or substantially equal to that of the second engaging portion 31b, to enable the second engaging portion 31b to smoothly pass through the notch 21b and enter the auxiliary speaker 2.

In a case where the driving structure 4 is in the first state, the second engaging portion 31b may be at least partially engaged into the auxiliary speaker 2 through the notch, to ensure the stable assembling of the auxiliary speaker 2 with the main speaker 1. In this case, the second engaging portion 31b may abut against the inner sidewall of the notch 21b. In a case where the driving structure 4 is in the second state, the second engaging portion 31b may be disposed in the notch 21b to facilitate the separation of the auxiliary speaker 2 from the main speaker 1. In this case, the second engaging portion 31b may be spaced apart from the inner sidewall of the notch 21b.

In some embodiments, the auxiliary speaker 2 may include at least one first magnetic structure (e.g., a magnet, see the first magnetic structure 22 shown in FIG. 1). The main speaker 1 may include at least one second magnetic structure (e.g., a magnet, see the second magnetic structure 12 shown in FIG. 1). The auxiliary speaker 2 and the main speaker 1 may be magnetically connected to each other by the magnetic attraction of the at least one first magnetic structure 22 and the at least one second magnetic structure 12.

In some embodiments, the splittable speaker assembly may include the main speaker 1 and the auxiliary speaker 2. The main speaker 1 may include the housing 11. The housing 11 may include the front shell 111 and the rear shell 112.

The rear shell 112 may define a carrying-handle groove 1122. During the assembly, the carrying handle may be assembled in the carrying-handle groove 1122 defined in the rear shell 112. The rotating shaft 421 may pass through the cam mechanism 42b and the second carrying handle portion 41b, and then be mounted to the rear shell 112 by means of, e.g., screws or other fasteners, such that the driving structure 4 is rotatable relative to the rear shell 112. The buckle structure 3 may be secured or fixed to a side surface of the rear shell 112 configured to be mated with the auxiliary speaker 2. A spring (the resilient member 33) may be mounted to the side surface of the rear shell 112. The second sliding portion 32b of the buckle structure 3 may abut against the cam 421b of the cam mechanism 42b. In some embodiments, a positioning post 321c may be disposed at an end of the second sliding portion 32b, the elastic member 33 may be sleeved on the positioning post 321c. One end of the elastic member 33 may abut against the second sliding portion 32b, and the other end of the second sliding portion 32b may abut against the rear shell 112. The front housing 111 and the rear shell 112 may be fixed together by screws. Other decorative members on both sides may be installed, and the assembly of the main speaker 1 and each of the above-described structures may be completed.

In some embodiments, when it is necessary to assemble the auxiliary speaker 2 with the main speaker 1, the auxiliary speaker 2 may be disposed close to or adjacent to the main speaker 1. In this case, the main speaker 1 and the auxiliary speaker 2 may be magnetically connected to each other by magnets pre-embedded in the main speaker 1 and the auxiliary speaker 2, such that the auxiliary speaker 2 may be attracted on the main speaker 1. In this case, the second engaging portion 31b may be aligned with the notch, i.e., the second engaging portion 31b may be located in the notch 21b.

When the splittable speaker assembly needs to be moved, the second carrying handle portion 41b may be rotated by 90°, such that the second carrying handle portion 41b is in the first state in which the second carrying handle portion 41b stands upright relative to the main speaker 1. The cam mechanism 42b may rotate along with the second carrying handle portion 41b, the second sliding portion 32b may be squeezed or compressed by the spring (the elastic member 33) below the second sliding portion 32b to move upwardly (move away from the elastic member 33 in the first direction). The second engaging portion 31b may move to a position in which the second engaging portion 31b is misaligned with the notch 21b in the auxiliary speaker 2. The second sliding portion 32b is locked in place, and the auxiliary speaker 2 is stably fixedly connected to the main speaker 1.

When it is necessary to separate the auxiliary speaker 2 from the main speaker 1, the second carrying handle portion 41b may be rotated to a second state in which the second carrying handle portion 41b may be substantially parallel to the upper surface of the main speaker 1, driving the cam 421b of the cam mechanism 42b to rotate, such that the second sliding portion 32b may be pressed downwardly by the cam mechanism 42b. The second engaging portion 31b may be moved downwardly and synchronously with the second sliding portion 32b. The second engaging portion 31b may be move to the position of the notch 21b of the auxiliary speaker 2 (i.e., the second engaging portion 31b is aligned with the notch 21b). In this way, the second engaging portion 31b may be unlocked, and the auxiliary speaker 2 may be removed from the main speaker 1.

For the splittable speaker assembly in some embodiments of the present disclosure, through the cooperation among the driving structure 4, the buckle structure 3, the engaging groove 210, and other structures, when the user is using the splittable speaker assembly, the assembling or separation of the main speaker 1 and the auxiliary speaker 2 may be completed by only one action of operating the handle portion. Besides, the splittable speaker assembly may have better the stability in a case where the auxiliary speaker 2 is assembled with the main speaker 1, the operation of the assembling and splitting/separation of the splittable speaker assembly may be facilitated, and the use experience may be improved.

According to a first aspect of some embodiments of the present disclosure, a splittable speaker assembly is provided. The splittable speaker assembly includes a main speaker, an auxiliary speaker including a mating portion; a buckle structure movably connected to the main speaker; and a driving structure, movably connected to the main speaker and abutting against an end of the buckle structure to drive the buckle structure to move. The mating portion is capable of being mated with the buckle structure. In a case where the driving structure is moved to a first state relative to the main speaker, the buckle structure is moved to a position where the buckle structure is engaged with the mating portion, such that the auxiliary speaker is engaged with the main speaker. In a case where the driving structure is moved to a second state relative to the main speaker, the buckle structure is moved to a position where the buckle structure is separated from the mating portion, such that the auxiliary speaker is disengaged from the main speaker.

In some embodiments, the driving structure is slidably connected to the main speaker and the buckle structure is slidably connected to the main speaker. In a case where the driving structure slides to the first state in a first direction relative to the main speaker, the buckle structure slides in a second direction to the position where the buckle structure is engaged with the mating portion, such that the auxiliary speaker is engaged with the main speaker. In a case where the driving structure slides to the second state in the first direction relative to the main speaker, the buckle structure slides in the second direction to the position where the buckle structure is separated from the mating portion, such that the auxiliary speaker is disengaged from the main speaker.

In some embodiments, the mating portion includes an engaging groove defined in the auxiliary speaker, and the engaging groove includes a first portion and a second portion communicating with each other. The buckle structure includes a first engaging portion and a first sliding portion, the first engaging portion is fixedly connected to the first sliding portion, the buckle structure abuts against the driving structure through an end of the first sliding portion, and the first sliding portion is configured to drive the first engaging portion to slide. In a case where the driving structure is in the first state, the first engaging portion is at least partially engaged into the second portion of the engaging groove under the driven of the first sliding portion. In a case where the driving structure is in the second state, the first engaging portion is located in the first portion of the engaging groove under the driven of the first sliding portion.

In some embodiments, an elastic member is arranged on another end of the first sliding portion. In a case where the driving structure is in the first state, the elastic member is in a state of elastic deformation, and the elastic force generated by the elastic deformation of the elastic member is configured to cause the first sliding portion to drive the first engaging portion to move in the direction of the first portion.

In some embodiments, the main speaker includes a housing, the driving structure includes a first carrying handle portion and a bracket portion, the first carrying handle portion is located on an outer side of the housing, the bracket portion is located on an inner side of the housing, and the driving structure abuts against the buckle structure through the bracket portion. The first carrying handle portion is fixedly connected to the bracket portion via a fastener.

In some embodiments, the bracket portion includes a positioning protrusion, and the splittable speaker assembly further defines a first positioning groove capable of being mated with the positioning protrusion, and the positioning protrusion is engaged into the first positioning groove in a case where the driving structure is in the first state; and/or the splittable speaker assembly defines a second positioning groove capable of being mated with the positioning protrusion, and the positioning protrusion is engaged into the second positioning groove in a case where the driving structure is in the second state.

In some embodiments, the driving structure is rotatably connected to the main speaker and the buckle structure is slidingly connected to the speaker body. The driving structure includes a second carrying handle portion and a cam mechanism, the second carrying handle portion is fixedly connected to the cam mechanism, a cam of the cam mechanism abuts against an end of the buckle structure, and an elastic member is arranged at another end of the buckle structure. In a case where the driving structure is moved to the first state relative to the main speaker, the buckle structure slides to the position where the buckle structure is engaged with the mating portion under the action of the cam mechanism, such that the auxiliary speaker is engaged with the main speaker; and in a case where the driving structure is moved to the second state relative to the main speaker, the buckle structure slides to the position where the buckle structure is separated from the mating portion under the action of the cam mechanism, such that the auxiliary speaker is disengaged from the main speaker.

In some embodiments, at least one of the following is satisfied: the main speaker defines a first limiting hole, a first limiting member is disposed on the cam, and the first limiting member is disposed in the first limiting hole and configured to limit the rotation of the driving structure relative to the main speaker; or a second limiting member is disposed on the main speaker, the buckle structure defines a second limiting hole extending in a first direction, and the second limiting member is disposed in the second limiting hole and configured to limit the sliding of the buckle structure relative to the main speaker.

In some embodiments, the buckle structure includes a second engaging portion and a second sliding portion, the second engaging portion is connected to the second sliding portion, the buckle structure abuts against the driving structure via the second sliding portion, and the second sliding portion is configured to drive the second engaging portion to slide relative to the main speaker. The mating portion includes a notch defined on the auxiliary speaker. In a case where the driving structure is in the first state, the second engaging portion is at least partially engaged into the auxiliary speaker via the notch; and in a case where the driving structure is in the second state, the second engaging portion is located in the notch.

In some embodiments, the auxiliary speaker includes at least one first magnetic structure, the main speaker includes at least one second magnetic structure, and the auxiliary speaker and the main speaker are magnetically connected by magnetic attraction of the at least one first magnetic structure and the at least one second magnetic structure. The buckle structure is aligned with the mating portion in a state where the auxiliary speaker is magnetically connected to the main speaker.

In some embodiments, a sliding direction of the driving structure is a first direction, a sliding direction of the buckle structure is a second direction, the first portion is recessed in a third direction and away from the buckle structure, and the second portion is recessed in the second direction and away from the driving structure. The third direction is substantially perpendicular to the first direction, and the third direction is substantially perpendicular to the second direction.

In some embodiments, an end of the first sliding portion has a first inclined surface, the driving structure has a second inclined surface, and the first inclined surface abuts against the second inclined surface; in a case where the first engaging portion is moved in a direction away from the second inclined surface, the first engaging portion is at least partially engaged into the second portion of the engaging groove; and in a case where the first engaging portion is moved in a direction close to the second inclined surface, the first engaging portion is exited from the second portion and located in the first portion of the engaging groove.

In some embodiments, a sliding direction of the driving structure is a first direction, the housing defines a through hole extending in the first direction, and the fastener is slidable in the through hole.

In some embodiments, at least one of the following is satisfied: a first rolling structure is arranged on a side of the first carrying handle portion close to the bracket portion; or a second rolling structure is arranged on a side of the bracket portion close to the first carrying handle portion.

In some embodiments, the splittable speaker assembly further comprises a positioning portion, the positioning portion is disposed in the housing and covers the bracket portion.

In some embodiments, the main speaker comprises a housing, and the buckle structure is fixedly connected to the housing; a positioning post is disposed at an end of the second sliding portion, the elastic member is sleeved on the positioning post, one end of the elastic member abuts against the second sliding portion, and the other end of the second sliding portion abut against the housing.

In some embodiments, a size of the notch matches with a size of the second engaging portion.

In some embodiments, an end of the buckle structure abuts against the driving structure, an elastic member is disposed at another end of the buckle structure, and the elastic member is configured to enable the buckle structure to keep abutting against the driving structure,
According to a second aspect of some embodiments of the present disclosure, a splittable speaker assembly is provided. The splittable speaker assembly includes a main speaker and an auxiliary speaker. The main speaker includes a housing, a buckle structure movably connected to the housing; and a driving structure, movably connected to the housing, abutting against an end of the buckle structure, and configured to drive the buckle structure to move. The auxiliary speaker includes a mating portion and is capable of being mated with the buckle structure. The driving structure is switchable between a first state and a second state. In a case where the driving structure is in the first state, the buckle structure is engaged with the mating portion, such that the auxiliary speaker is engaged with the main speaker. In a case where the driving structure is in the second state, the buckle structure is separated from the mating portion, such that the auxiliary speaker is disengaged from the main speaker.

According to a third aspect of some embodiments of the present disclosure, a main speaker for a splittable speaker assembly is provided. The splittable speaker assembly includes an auxiliary speaker. The main speaker includes a housing, a buckle structure movably connected to the housing; and a driving structure, movably connected to the housing, abutting against an end of the buckle structure, and configured to drive the buckle structure to move. The auxiliary speaker includes a mating portion and is capable of being mated with the buckle structure. The driving structure is switchable between a first state and a second state. In a case where the driving structure is in the first state, the buckle structure is engaged with the auxiliary speaker, such that the auxiliary speaker is engaged with the main speaker. In a case where the driving structure is in the second state, the buckle structure is separated from the auxiliary speaker, such that the auxiliary speaker is disengaged from the main speaker.

It is to be understood that the terms used herein are for the purpose of describing some example embodiments only and are not intended to be limiting. Unless expressly specified otherwise in the context, the singular forms "a", "an", and "the" as used herein may also encompass plural forms. The terms "comprise", "include", "contain", and "have" are inclusive and thus specify the presence of the stated features, steps, operations, elements, and/or components, but do not exclude the presence or addition of one or more other features, steps, operations, elements, components, and/or combinations thereof. The method steps, processes, and operations described herein shall not be construed as requiring execution in the specific order described or illustrated, unless the execution sequence is explicitly stated. It shall also be understood that additional or alternative steps may be employed.

Although terms such as "first," "second," "third," etc., may be used herein to describe multiple elements, components, regions, layers, and/or sections, these elements, components, regions, layers, and/or sections should not be limited by these terms. These terms may be used solely to distinguish one element, component, region, layer, or section from another region, layer, or section. Unless explicitly stated in the context, terms including "first" and "second" as well as other numerical terminology do not imply order or sequence when used herein. Thus, a first element, component, region, layer, or section discussed below may be termed a second element, component, region, layer, or section without departing from the teachings of the example embodiments.

The above descriptions are merely some embodiments of the present disclosure, enabling those skilled in the art to understand and implement the present disclosure. Various modifications to these embodiments will be apparent to those skilled in the art. The general principles defined herein may be implemented in other embodiments without departing from the spirit or scope of the present disclosure. Therefore, the present disclosure shall not be limited to the embodiments illustrated herein, but shall be accorded the broadest scope consistent with the principles and novel features disclosed herein.

## Claims

1. A splittable speaker assembly, comprising:
a main speaker (1);
an auxiliary speaker (2), comprising a mating portion (21);
a buckle structure (3), movably connected to the main speaker (1); and
a driving structure (4), movably connected to the main speaker (1) and abutting against an end of the buckle structure (3) to drive the buckle structure (3) to move;
wherein the mating portion (21) is capable of being mated with the buckle structure (3);
wherein in a case where the driving structure (4) is moved to a first state relative to the main speaker (1), the buckle structure (3) is moved to a position where the buckle structure (3) is engaged with the mating portion (21), such that the auxiliary speaker (2) is engaged with the main speaker (1); and
in a case where the driving structure (4) is moved to a second state relative to the main speaker (1), the buckle structure (3) is moved to a position where the buckle structure (3) is separated from the mating portion (21), such that the auxiliary speaker (2) is disengaged from the main speaker (1).

2. The splittable speaker assembly as claimed in claim 1, wherein the driving structure (4) is slidably connected to the main speaker (1) and the buckle structure (3) is slidably connected to the main speaker (1);
wherein in a case where the driving structure (4) slides to the first state in a first direction relative to the main speaker (1), the buckle structure (3) slides in a second direction to the position where the buckle structure (3) is engaged with the mating portion (21), such that the auxiliary speaker (2) is engaged with the main speaker (1); and
in a case where the driving structure (4) slides to the second state in the first direction relative to the main speaker (1), the buckle structure (3) slides in the second direction to the position where the buckle structure (3) is separated from the mating portion (21), such that the auxiliary speaker (2) is disengaged from the main speaker (1).

3. The splittable speaker assembly as claimed in claim 2, wherein the mating portion (21) comprises an engaging groove (210) defined in the auxiliary speaker (2), and the engaging groove (210) comprises a first portion (211) and a second portion (212) communicating with each other;
wherein the buckle structure (3) comprises a first engaging portion (31a) and a first sliding portion (32a), the first engaging portion (31a) is fixedly connected to the first sliding portion (32a), the buckle structure (3) abuts against the driving structure (4) through an end of the first sliding portion (32a), and the first sliding portion (32a) is configured to drive the first engaging portion (31a) to slide;
in a case where the driving structure (4) is in the first state, the first engaging portion (31a) is at least partially engaged into the second portion (212) of the engaging groove (210) under the driven of the first sliding portion (32a); and
wherein in a case where the driving structure (4) is in the second state, the first engaging portion (31a) is located in the first portion (211) of the engaging groove under the driven of the first sliding portion (32a).

4. The splittable speaker assembly as claimed in claim 3, wherein an elastic member (33) is arranged on another end of the first sliding portion (32a);
wherein in a case where the driving structure (4) is in the first state, the elastic member (33) is in a state of elastic deformation, and the elastic force generated by the elastic deformation of the elastic member (33) is configured to cause the first sliding portion (32a) to drive the first engaging portion (31a) to move in the direction of the first portion (211).

5. The splittable speaker assembly as claimed in claim 3, wherein a sliding direction of the driving structure (4) is a first direction (X), a sliding direction of the buckle structure (3) is a second direction (Y), the first portion (211) is recessed in a third direction (Z) and away from the buckle structure (3), and the second portion (212) is recessed in the second direction (Y) and away from the driving structure (4);
wherein the third direction (Z) is substantially perpendicular to the first direction (X), and the third direction (Z) is substantially perpendicular to the second direction (Y).

6. The splittable speaker assembly as claimed in claim 3, wherein an end of the first sliding portion (32a) has a first inclined surface (321a), the driving structure (4) has a second inclined surface (421a), and the first inclined surface (321a) abuts against the second inclined surface (421a);
in a case where the first engaging portion (31a) is moved in a direction away from the second inclined surface (421a), the first engaging portion (31a) is at least partially engaged into the second portion (212) of the engaging groove (210); and
in a case where the first engaging portion (31a) is moved in a direction close to the second inclined surface (421a), the first engaging portion (31a) is exited from the second portion (212) and located in the first portion (211) of the engaging groove (210).

7. The splittable speaker assembly as claimed in claim 2, wherein the main speaker (1) comprises a housing (11), the driving structure (4) comprises a first carrying handle portion (41a) and a bracket portion (42a), the first carrying handle portion (41a) is located on an outer side of the housing (11), the bracket portion (42a) is located on an inner side of the housing (11), and the driving structure (4) abuts against the buckle structure (3) through the bracket portion (42a); and
wherein the first carrying handle portion (41a) is fixedly connected to the bracket portion (42a) via a fastener (411a).

8. The splittable speaker assembly as claimed in claim 7, wherein the bracket portion (42a) comprises a positioning protrusion (421), and the splittable speaker assembly further defines a first positioning groove (51) capable of being mated with the positioning protrusion (421), and the positioning protrusion (421) is engaged into the first positioning groove (51) in a case where the driving structure (4) is in the first state; and/or
the splittable speaker assembly defines a second positioning groove (52) capable of being mated with the positioning protrusion (421), and the positioning protrusion (421) is engaged into the second positioning groove (52) in a case where the driving structure (4) is in the second state.

9. The splittable speaker assembly as claimed in claim 7, wherein a sliding direction of the driving structure (4) is a first direction (X), the housing (11) defines a through hole (1121) extending in the first direction (X), and the fastener (411a) is slidable in the through hole (1121).

10. The splittable speaker assembly as claimed in claim 7, further comprising a positioning portion (5), wherein the positioning portion (5) is disposed in the housing (11) and covers the bracket portion (42a).

11. The splittable speaker assembly as claimed in claim 1, wherein the driving structure (4) is rotatably connected to the main speaker (1) and the buckle structure (3) is slidingly connected to the speaker body;
wherein the driving structure (4) comprises a second carrying handle portion (41b) and a cam mechanism (42b), the second carrying handle portion (41b) is fixedly connected to the cam mechanism (42b), a cam (421) of the cam mechanism (42b) abuts against an end of the buckle structure (3), and an elastic member (33) is arranged at another end of the buckle structure (3);
in a case where the driving structure (4) is moved to the first state relative to the main speaker (1), the buckle structure (3) slides to the position where the buckle structure (3) is engaged with the mating portion (21) under the action of the cam mechanism (42b), such that the auxiliary speaker (2) is engaged with the main speaker (1); and
in a case where the driving structure (4) is moved to the second state relative to the main speaker (1), the buckle structure (3) slides to the position where the buckle structure (3) is separated from the mating portion (21) under the action of the cam mechanism (42b), such that the auxiliary speaker (2) is disengaged from the main speaker (1).

12. The splittable speaker assembly as claimed in claim 11, wherein at least one of the following is satisfied:
the main speaker (1) defines a first limiting hole (11b), a first limiting member is disposed on the cam (421), and the first limiting member is disposed in the first limiting hole (11b) and configured to limit the rotation of the driving structure (4) relative to the main speaker (1); or
a second limiting member is disposed on the main speaker (1), the buckle structure (3) defines a second limiting hole (321b) extending in a first direction (X), and the second limiting member is disposed in the second limiting hole (321b) and configured to limit the sliding of the buckle structure (3) relative to the main speaker (1).

13. The splittable speaker assembly as claimed in claim 11, wherein the buckle structure (3) comprises a second engaging portion (31b) and a second sliding portion (32b), the second engaging portion (31b) is connected to the second sliding portion (32b), the buckle structure (3) abuts against the driving structure (4) via the second sliding portion (32b), and the second sliding portion (32b) is configured to drive the second engaging portion (31b) to slide relative to the main speaker (1);
the mating portion (21) comprises a notch (21b) defined on the auxiliary speaker (2);
wherein in a case where the driving structure (4) is in the first state, the second engaging portion (31b) is at least partially engaged into the auxiliary speaker (2) via the notch (21b); and
in a case where the driving structure (4) is in the second state, the second engaging portion (31b) is located in the notch (21b).

14. The splittable speaker assembly as claimed in any one of claims 1-13, wherein the auxiliary speaker (2) comprises at least one first magnetic structure (22), the main speaker (1) comprises at least one second magnetic structure (12), and the auxiliary speaker (2) and the main speaker (1) are magnetically connected by magnetic attraction of the at least one first magnetic structure (22) and the at least one second magnetic structure (12); and
wherein the buckle structure (3) is aligned with the mating portion (21) in a state where the auxiliary speaker (2) is magnetically connected to the main speaker (1).

15. The splittable speaker assembly as claimed in claim 1, wherein an end of the buckle structure (3) abuts against the driving structure (4), an elastic member (33) is disposed at another end of the buckle structure (3), and the elastic member (33) is configured to enable the buckle structure (3) to keep abutting against the driving structure (4).
